# EUROPEAN PATENT APPLICATION

(11) **EP 4 819 782 A1**
(43) Date of publication of application: **07.10.2026**
(21) Application number: 26169003.6
(22) Date of filing: 30.03.2026
(51) Int. Cl.: H05K 7/20

(54) **HYBRID IMMERSION COOLING**

(30) Priority: 31.03.2025 US 202563781164 P
(71) Applicant: Nortek Air Solutions, LLC, Okarche, Oklahoma 73762 (US)
(72) Inventor: Von Zur Muehlen, Patrick Alexander, Wildwood (US)
(74) Representative: Marks & Clerk LLP

(57) **Abstract**

An immersion liquid cooling device (100) includes a base (110), a cover (112), a liquid inlet (114), and a liquid outlet (116). The base is configured to be connected to one of two major surfaces of a motherboard (102) and to surround one or more heat generating components (106, 108) connected to the motherboard. The cover is connected to the base. The base, the cover, and a portion of the one of two major surfaces of the motherboard form a sealed liquid cooling chamber (117). A dielectric liquid is configured to flow into and out of the cooling chamber through the liquid inlet and the liquid outlet.

## Description

### BACKGROUND

Direct liquid cooling (DLC) has become an increasingly viable solution for high-performance computing (HPC), data centers, and even enthusiast-level PC builds. DLC technologies directly cool components like CPUs, GPUs, and memory modules using liquid coolant, which can provide increased thermal performance relative to other cooling mediums and/or systems, e.g. air cooling.

DLC systems include direct-to-chip cooling systems an example of which are cold plate(s) that can attach directly to heat-generating components (CPUs, GPUs, memory, power delivery circuits)and transfer heat from the target component(s) to a circulating liquid coolant, which can then be pumped away for heat dissipation, e.g. to another HVAC component or system that is configured to cool the heated liquid before it is returned to the DLC.

Additionally, DLC systems can include immersion cooling systems in which part or all of a heat-generating device is submerged in a liquid coolant. Such systems employ dielectric liquid coolants that prevent or quench electrical discharges as they cool heat-generating components.

Both cold plate or other direct-to-chip systems and immersion cooling can be highly effective, and selection between or combining them in a hybrid system DLC system can depend on a number of parameters, e.g. thermal conductivity, heat transfer efficiency, and application. At least in some cases, immersion cooling can offer superior heat transfer and cooling density relative to cold plate DLC. However, cold plate DLC is often preferred due to a number of practical considerations, including modularity, maintainability, and easier integration. For example, cold plate DLC systems integrate more easily into existing infrastructure, making them better for retrofitting to high-power computing (HPC) and enterprise servers.

### SUMMARY

Examples according to this disclosure are directed to systems and methods for direct liquid cooling that is a hybrid between immersion and cold plate cooling in the sense that such examples include immersion liquid cooling that offers superior performance levels while also having at least some of the practical advantages of cold plate cooling in modularity, maintainability, and integration.

In an example according to this disclosure, an immersion liquid cooling device includes a base, a cover, a liquid inlet, and a liquid outlet. The base is configured to be connected to one of two major surfaces of a motherboard and to surround one or more heat generating components connected to the motherboard. The cover is connected to the base. The base, the cover, and a portion of the one of two major surfaces of the motherboard form a sealed liquid cooling chamber. A dielectric liquid is configured to flow into and out of the cooling chamber through the liquid inlet and the liquid outlet.

In another example according to this disclosure, an immersion liquid cooling device includes a first enclosure, a second enclosure, a liquid inlet, and a liquid outlet. The first enclosure is configured to be connected to one of two major surfaces of a motherboard and to surround one or more heat generating components connected to the one of two major surfaces of the motherboard. The second enclosure is configured to be connected to another of the two major surfaces of the motherboard opposite of the one of two major surfaces of the motherboard. The first enclosure and the second enclosure are fluidically connected and form a sealed liquid cooling chamber. A dielectric liquid is configured to flow into and out of the cooling chamber through the liquid inlet and the liquid outlet.

In another example according to this disclosure, a method of cooling an electronic device includes enclosing fewer than all of a plurality of heat generating components connected to a motherboard in a sealed liquid cooling chamber of an immersion liquid cooling device connected to the motherboard and circulating a dielectric liquid through the cooling chamber to cool the fewer than all of the plurality of heat generating components.

This overview is intended to provide an overview of subject matter in the present application. It is not intended to provide an exclusive or exhaustive explanation of the invention. The detailed description is included to provide further information about the present application.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIGS. 1A-1C depict an example immersion liquid cooling device according to this disclosure.
FIGS. 2A-2C depict another example immersion liquid cooling device according to this disclosure.
FIG. 3 depicts an example method according to this disclosure.

### DESCRIPTION

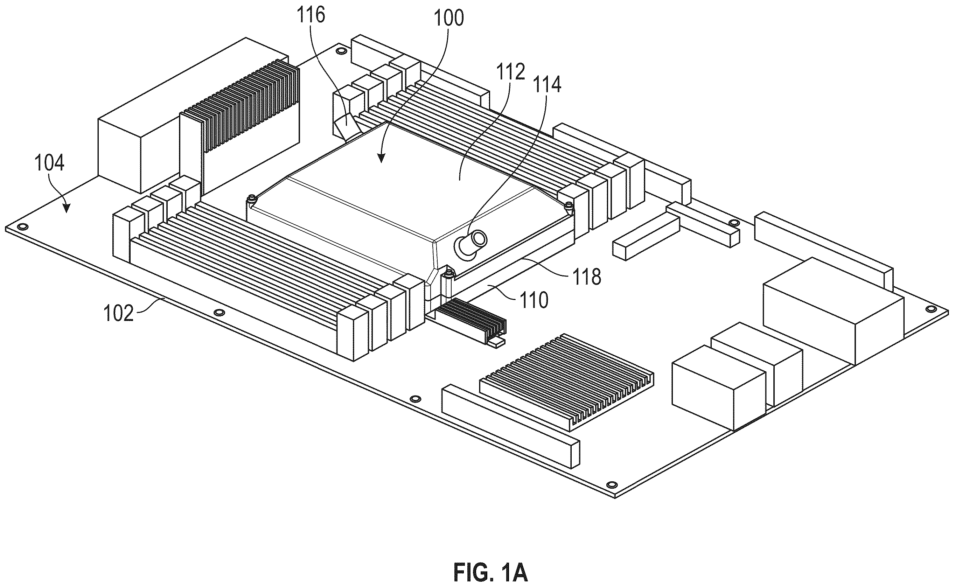

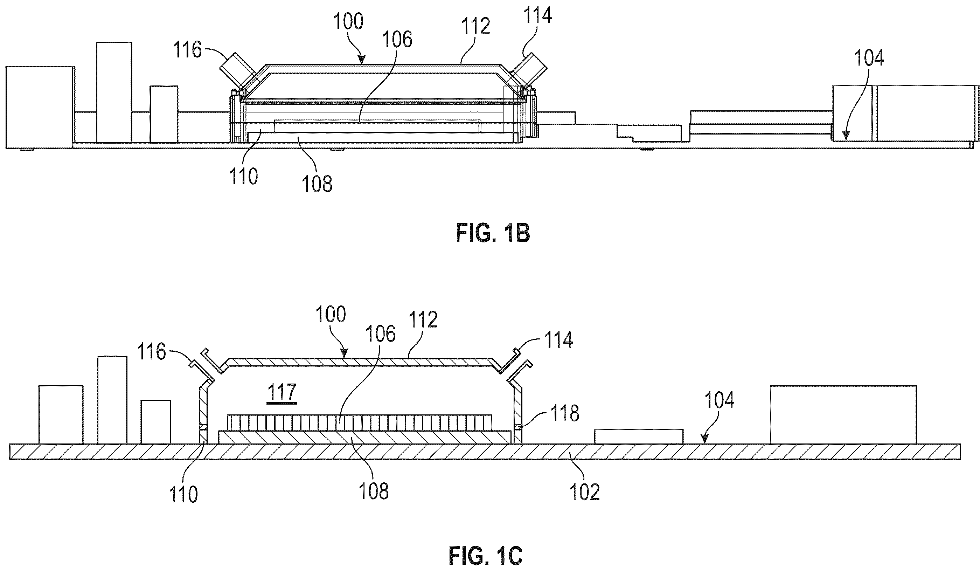

FIGS. 1A-1C depict example immersion liquid cooling (ILC) device 100 connected to a computer motherboard 102. Motherboard 102 includes a plurality of components connected to first major surface 104 of the motherboard. ILC device 100 surrounds and encloses a select number of the components connected to motherboard 102. In the example of FIGS. 1A-1C, ILC device 100 surrounds and encloses first component 106 and second component 108. In other examples, ILC device 100 and other ILC devices according to this disclosure can surround and enclose fewer or more two components on a motherboard.

ILC device 100 includes base 110, cover 112, and liquid inlet 114 and liquid outlet 116. Base 110 is connected to first major surface 104 of motherboard 102. For example, base 110 can be connected to first major surface 104 using fastener(s), adhesives, epoxies, and combinations thereof. Cover 112 is connected to base 110. Base 110 and cover 112 can also be connected in a number ways/via a number of mechanisms, including fasteners, adhesives, epoxies, and combinations thereof. Regardless of the coupling method/mechanism of base 110 to motherboard 102 and cover 112 to base 110, base 110, cover 112, and first major surface 104 form sealed cooling chamber 117. In an example, seal 118 is interposed between cover 112 and base 110 to form sealed cooling chamber 117. In examples, seal 118 can function to connect and/or seal cover 112 and base 110.

In examples, seal 118 can include a silicone, epoxy, polyurethane, fluoropolymer based, or fluorinated ethylene propylene (FEP) adhesive, which connects and seals cover 112 and base 110. In an example, seal 118 includes a silicone-based adhesives, e.g., Dow Corning 795 and 732, which connects and seals cover 112 and base 110. In an example, seal 118 includes a 2K epoxy-based adhesive, e.g., Curran 1000T, 3M 2216, or Loctite epoxy instant mix. In an example, seal 118 includes a polyurethane-based adhesive, e.g., 3M PU500, which connects and seals cover 112 and base 110. In an example, seal 118 includes a fluoropolymer-based adhesives, e.g., DuPont Teflon AF. In an example, seal 118 includes a fluorinated ethylene propylene (FEP) adhesive.

In examples, cover 112 and base 110 of ILC device 100 can be mechanically coupled, e.g. with fasteners. In such examples, seal 118 can include a gasket that functions to seal the mechanically connected cover 112 and base 110. Base 110 can be connected to and sealed with motherboard 102 in a similar manner as described with reference to cover 112 and base 110. In examples, a seal or gasket can be interposed between base 110 and motherboard 102. In examples, a silicone, epoxy, polyurethane, fluoropolymer based, or fluorinated ethylene propylene (FEP) adhesive can connect and seal base 110 and motherboard 102. In another example, fastener(s) can connect base 110 to motherboard 102 with a gasket interposed therebetween to form a seal at the junction between the base and the motherboard.

Cover 112 and base 110 can be manufactured from a variety of materials that are compatible with dielectric fluids employed for liquid cooling by ILC device 100 and that have other advantageous properties for applications of the device, including corrosion resistance, structurally strong and durable, non-conductive, thermally stable, high operating temperature, cost/availability, ease of fabrication, as examples. For example, cover 112 and/or base 110 can be fabricated from polymers, including fiberglass-reinforced (FRP) or carbon fiber-reinforced (CFRP) polymers, epoxies, elastomers, and combinations thereof. In examples, cover 112 and/or base 110 can include polycarbonate, acrylic, high density polyethylene (HDPE), polypropylene, epoxy resin, polytetrafluoroethylene (PTFE), and combinations thereof. In examples, cover 112 and/or base 110 can include elastomers including ethylene propylene diene monomer (EPDM) rubber, silicone, neoprene, and combinations thereof.

In examples according to this disclosure, ILC device 100 can be retrofitted to an existing installation including motherboard 102 and first component 106 and second component 108. Additionally, ILC device 100 can be incorporated into a server or other computing device including motherboard 102 and first component 106 and second component 108, e.g., prior to installation of the server in a data center rack. Regardless of whether retrofitting to an already installed server or fitted to/included in a new server installation, ILC device 100 is configured to cool a select number of components (e.g. fewer than all of a plurality of components) connected to a motherboard, e.g., first component 106 and second component 108 connected to motherboard 102. In examples according to this disclosure, a dielectric fluid is circulated into liquid inlet 114, through cooling chamber 117, and out of liquid outlet 116 to provide direct liquid cooling of first component 106 and second component 108.

Liquid inlet 114 and/or liquid outlet 116 can include quick connect/disconnect connections and/or self-sealing valves to allow liquid supply circuit(s) to be quickly and efficiently connected to and disconnected from ILC device 100. Additionally, base 110 and/or cover 112 can include additional heat transfer and/or fluid flow structures on internal and/or external surfaces thereof. For example, one or more inside surfaces of base 110 and/or cover 112 can include flow director(s), e.g., baffles, turbulators, or other structures for directing or otherwise modulating characteristics of the dielectric liquid flowing through sealed cooling chamber 117. For example, one or more flow directors can extend from inside surfaces of base 110 and/or cover 112 to direct liquid flow toward particular heat generating components within sealed cooling chamber 117, e.g., toward first component 106 and/or second component 108. Additionally, or alternatively, one or more inside surfaces of base 110 and/or cover 112 can include fins, corrugations, crenulations, scallops, notches, or other surface features that provide additional heat transfer surface area to ILC device 100. In examples employ two phase dielectric liquids, one or more nozzles may be incorporated into ILC device 100 and/or connected to a liquid supply circuit connected to the device.

In examples of ILC device 100, part or all of motherboard 102, e.g. first major surface 104 or a portion thereof may be coated to provide liquid sealing and/or other protective characteristics. For example, part or all of motherboard 102, including part or all of first major surface 104 may include a conformal coating. Conformal coating is a protective coating of thin polymeric film applied that is commonly applied to printed circuit boards (PCBs). A thin layer of conformal coating, e.g. 25-250 µm thickness can be applied to part or all of motherboard 102, including part or all of first major surface 104 to protect against moisture and other substances. The conformal coating can be applied in different ways, including brushing, spraying, dispensing, and dip coating. In examples, the conformal coating can include a variety of polymers, including, e.g., acrylic, silicone, urethane, and parylene.

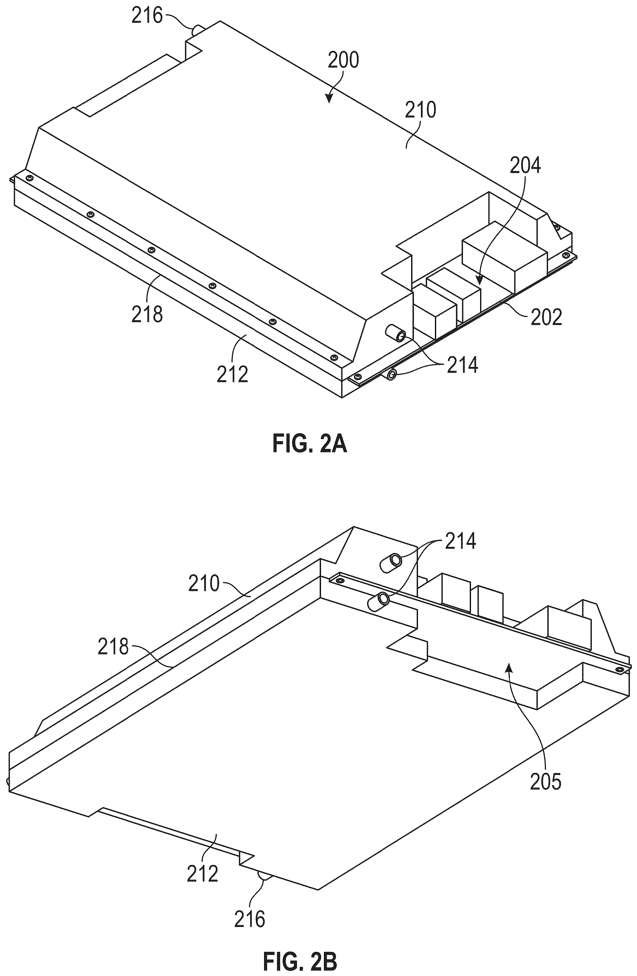

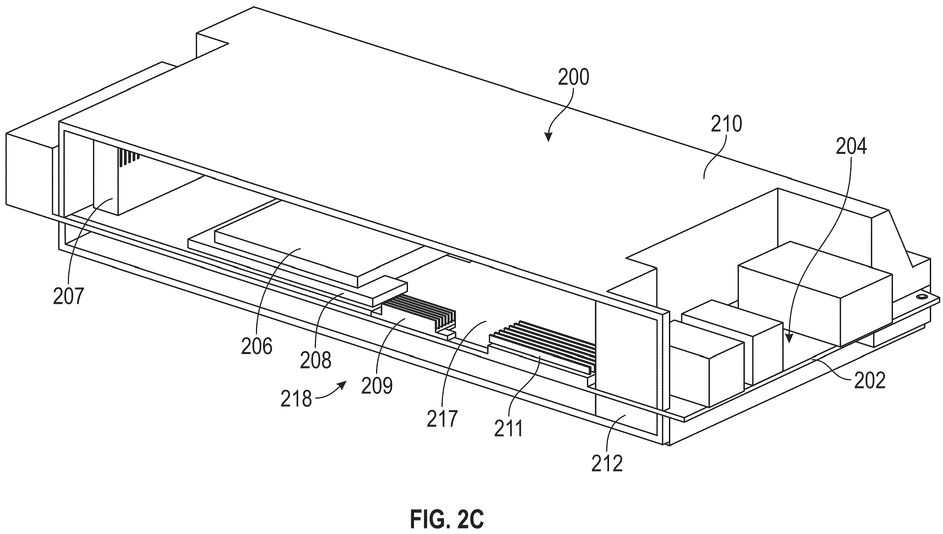

FIGS. 2A-2C depict another example immersion liquid cooling (ILC) device 200 according to this disclosure. ILC device 200 is connected to a computer motherboard 202. Motherboard 202 includes a plurality of components connected to first major surface 204 of the motherboard. ILC device 200 surrounds and encloses a select number of the components connected to motherboard 202. In the example of FIGS. 2A-2C, ILC device 200 surrounds and encloses first component 206, second component 207, third component 208, fourth component 209, and fifth component 211 (shown in FIG. 2A). In other examples, ILC device 200 and other ILC devices according to this disclosure can surround and enclose fewer or more components on a motherboard.

ILC device 200 includes first enclosure 210 and second enclosure 212. Each of first enclosure 210 and second enclosure 212 includes liquid inlet 214 and liquid outlet 216 (only one of which is viewable in the perspective of FIG. 2B). First enclosure 210 is connected to first major surface 201 of motherboard 202 and extends beyond an edge of the motherboard to connect to second enclosure 212. Second enclosure 212 is connected to second major surface 205 of motherboard 202 opposite first major surface 204 and extends beyond the edge of the motherboard to connect to second enclosure.

First enclosure 210 can be connected to first major surface 104 and second enclosure 212 in variety of ways. Similarly, second enclosure 212 can be connected to second major surface 105 and first enclosure 210 in variety of ways. For example, first enclosure 210, second enclosure 212, first and second major surfaces 204, 205 of motherboard 202 can be interconnected using fastener(s), adhesives, epoxies, and combinations thereof. Regardless of the coupling method/mechanism, first enclosure 210, second enclosure 212, first and second major surfaces 204, 205 of motherboard 202 form sealed cooling chamber 217. In an example, seal 218 is interposed between first enclosure 210 and second enclosure 212 to form a seal therebetween. A similar seal can be interposed between first enclosure 210 and first major surface 204 of motherboard 202 and between second enclosure 212 and second major surface 205 of motherboard 202. In examples, seal 218 can function to connect and/or first enclosure 210 and seal second enclosure 212.

In examples, seal 218 (and other seals, e.g., between first enclosure 210 and first major surface 204 of motherboard 202 and between second enclosure 212 and second major surface 205 of motherboard 202) can include a silicone, epoxy, polyurethane, fluoropolymer based, or fluorinated ethylene propylene (FEP) adhesive, which connects and seals second enclosure 212 and first enclosure 210. In an example, seal 218 includes a silicone-based adhesives, e.g., Dow Corning 795 and 732, which connects and seals second enclosure 212 and first enclosure 210. In an example, seal 218 includes a 2K epoxy-based adhesive, e.g., Curran 1000T, 3M 2216, or Loctite epoxy instant mix. In an example, seal 218 includes a polyurethane-based adhesive, e.g., 3M PU500, which connects and seals second enclosure 212 and first enclosure 210. In an example, seal 218 includes a fluoropolymer-based adhesives, e.g., DuPont Teflon AF. In an example, seal 118 includes a fluorinated ethylene propylene (FEP) adhesive.

In examples, second enclosure 212 and first enclosure 210 of ILC device 200 can be mechanically coupled, e.g. with fasteners. In such examples, seal 218 can include a gasket that functions to seal the mechanically connected second enclosure 212 and first enclosure 210. First enclosure 210 and second enclosure 212 can be connected to and sealed with motherboard 202 in a similar manner as described with reference to second enclosure 212 and first enclosure 210. In examples, a seal or gasket can be interposed between first enclosure 210 and second enclosure 212 and motherboard 202. In examples, a silicone, epoxy, polyurethane, fluoropolymer based, or fluorinated ethylene propylene (FEP) adhesive can connect and seal first enclosure 210, second enclosure 212, and motherboard 202. In another example, fastener(s) can connect first enclosure 210 and second enclosure 212 to motherboard 202 with a gasket interposed therebetween to form a seal at the junction between the enclosures of ILC device 200 and the motherboard.

First enclosure 210 and second enclosure 212 can be manufactured from a variety of materials that are compatible with dielectric fluids employed for liquid cooling by ILC device 200 and that have other advantageous properties for applications of the device, including corrosion resistance, structurally strong and durable, non-conductive, thermally stable, high operating temperature, cost/availability, ease of fabrication, as examples. For example, first enclosure 210 and/or second enclosure 212 can be fabricated from polymers, including fiberglass-reinforced (FRP) or carbon fiber-reinforced (CFRP) polymers, epoxies, elastomers, and combinations thereof. In examples, first enclosure 210 and/or second enclosure 212 can include polycarbonate, acrylic, high density polyethylene (HDPE), polypropylene, epoxy resin, polytetrafluoroethylene (PTFE), and combinations thereof. In examples, first enclosure 210 and/or second enclosure 212 can include elastomers including ethylene propylene diene monomer (EPDM) rubber, silicone, neoprene, and combinations thereof.

In examples according to this disclosure, ILC device 200 can be retrofitted to an existing installation including motherboard 202 and first component 206, second component 207, third component 208, fourth component 209, and fifth component 211. Additionally, ILC device 200 can be incorporated into a server or other computing device including motherboard 202 and first component 206, second component 207, third component 208, fourth component 209, and fifth component 211, e.g., prior to installation of the server in a data center rack. Regardless of whether retrofitting to an already installed server or fitted to/included in a new server installation, ILC device 200 is configured to cool a select number of components (e.g. fewer than all of a plurality of components) connected to a motherboard, e.g., first component 206, second component 207, third component 208, fourth component 209, and fifth component 211 connected to motherboard 202. In examples according to this disclosure, a dielectric fluid is circulated into liquid inlets 214, through cooling chamber 217, and out of liquid outlets 216 to provide direct liquid cooling of first component 206, second component 207, third component 208, fourth component 209, and fifth component 211.

Liquid inlets 214 and/or liquid outlets 216 can include quick connect/disconnect connections and/or self-sealing valves to allow liquid supply circuit(s) to be quickly and efficiently connected to and disconnected from ILC device 200. Additionally, first enclosure 210 and/or second enclosure 212 can include additional heat transfer and/or fluid flow structures on internal and/or external surfaces thereof. For example, one or more inside surfaces of first enclosure 210 and/or second enclosure 212 can include flow director(s), e.g., baffles, turbulators, or other structures for directing or otherwise modulating characteristics of the dielectric liquid flowing through sealed cooling chamber 217. For example, one or more flow directors can extend from inside surface(s) of first enclosure 210 to direct liquid flow toward particular heat generating components within sealed cooling chamber 117, e.g., toward first component 206, second component 207, third component 208, fourth component 209, and/or fifth component 211. Additionally, or alternatively, one or more inside surfaces of first enclosure 210 and/or second enclosure 212 can include fins, corrugations, crenulations, scallops, notches, or other surface features that provide additional heat transfer surface area to ILC device 200. In examples employing two phase liquid coolants, one or more nozzles may be incorporated into ILC device 200 and/or connected to a liquid supply circuit connected to the device.

ILC devices 100, 200 and other example liquid immersion cooling devices according to this disclosure may offer superior performance levels relative to other non-immersion cooling devices and systems, e.g., cold plate cooling devices, while also having at least some of the practical advantages of cold plate cooling in modularity, maintainability, and integration. Direct liquid cooling component(s) of a server or other electronic device can offer a number of benefits over other cooling methods and systems, including cold plate or other liquid systems as well as air cooling systems.

For example, examples according to this disclosure may offer improved heat transfer efficiency, because the components being cooled are immersed in the liquid versus contact with only select surfaces in the case of cold plate systems and also, more generally, liquid has superior heat transfer performance relative to other cooling fluids like air, including higher thermal conductivity, heat carrying capacity, and heat transfer coefficient, as examples. Liquid immersion cooling can also offer higher energy efficiency. For example, some liquid immersion cooling methods and systems can be up to 80% more energy-efficient than cold plate methods, which can result in improved Power Usage Effectiveness (PUE) and significant energy output reduction. Example immersion liquid cooling devices and methods according to this disclosure may also achieve improved cooling capacity relative to other liquid cooling systems and air-cooling systems, because immersion liquid cooling can handle higher heat loads relative to other types of cooling systems and methods. As a result of such practical and inherent performance benefits of liquid immersion cooling systems and methods, they can increase power density and thereby improve applicability to advanced implementations like high-density and hyperscale data centers.

A variety of dielectric liquids can be employed with ILC devices 100, 200 and other example devices and methods according to this disclosure. For example, fluorocarbon (FC), hydrofluoroether (HFE), fluoropolyether (FPE), synthetic oil, fluoroketone (FK) based single- or two-phase dielectric liquids can be employed in examples according to this disclosure. In examples, single phase dielectric liquids employed in examples according to this disclosure can include 3M Fluoroinert fluids, e.g., FC-40, FC-3283, 3M Novec fluids, e.g., Novec 7500, Novec 7700, Solvay Galden HT-170, Synfluid PAO 6, ElectroCool EC-110, DSI OptiCool, Shell S3X, and Sumber SmartCoolant. In examples, two-phase dielectric liquids employed in examples according to this disclosure can include 3M fluoroinert fluids, e.g., FC-3284, FC-72, 3M Novec fluids, e.g., Novec 649, Novec 7000, Novec 7100, Solvay HT-55 - FPE, and OFZ17 - FC.

In examples of ILC device 200, part or all of motherboard 202, e.g. first major surface 104 and/or second major surface 205 or a portions thereof may be coated to provide liquid sealing and/or other protective characteristics. For example, part or all of motherboard 202, including part or all of first major surface 104 and/or second major surface 205 may include a conformal coating. A thin layer of conformal coating, e.g. 25-250 µm thickness can be applied to part or all of motherboard 202, including part or all of first major surface 104 and/or second major surface 205 to protect against moisture and other substances. The conformal coating can be applied in different ways, including brushing, spraying, dispensing, and dip coating. In examples, the conformal coating can include a variety of polymers, including, e.g., acrylic, silicone, urethane, and parylene.

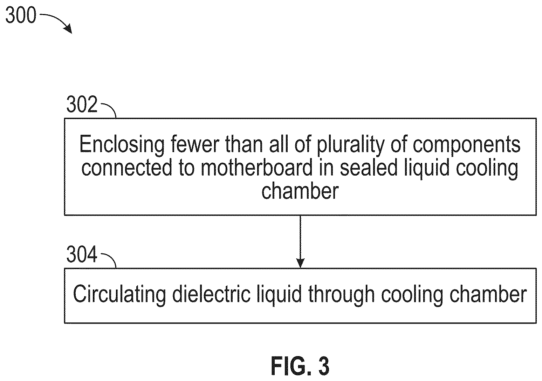

FIG. 3 is a flowchart depicting example method (300) of cooling an electronic device. Method 300 includes enclosing fewer than all of a plurality of heat generating components connected to a motherboard in a sealed liquid cooling chamber of an immersion liquid cooling device connected to the motherboard (302), and circulating a dielectric liquid through the cooling chamber to cool the fewer than all of the plurality of heat generating components (304).

In an example of method 300, the immersion liquid cooling device includes a base, a cover, a liquid inlet, and a liquid outlet. The base is connected to one of two major surfaces of the motherboard and to surround the fewer than all of a plurality of heat generating components connected to the motherboard. The cover is connected to the base. The base, the cover, and a portion of the one of two major surfaces of the motherboard form the sealed liquid cooling chamber. The dielectric liquid flows into and out of the cooling chamber through the liquid inlet and the liquid outlet.

In another example of method 300, the immersion liquid cooling device includes a first enclosure, a second enclosure, a liquid inlet, and a liquid outlet. The first enclosure is connected to one of two major surfaces of the motherboard and to surround the fewer than all of a plurality of heat generating components connected to the one of two major surfaces of the motherboard. The second enclosure is connected to another of the two major surfaces of the motherboard opposite of the one of two major surfaces of the motherboard. The first enclosure and the second enclosure are fluidically connected and form the sealed liquid cooling chamber. The dielectric liquid flows into and out of the cooling chamber through the liquid inlet and the liquid outlet.

The above description includes references to the accompanying drawings, which form a part of the description. The drawings show, by way of illustration, specific embodiments in which the invention can be practiced. These embodiments are also referred to herein as "examples." Such examples can include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Further, the code can be tangibly stored on one or more volatile or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

Examples, as described herein, may include, or may operate on, logic or a number of components, modules, or mechanisms. Modules may be hardware, software, or firmware communicatively coupled to one or more processors in order to carry out the operations described herein. Modules may hardware modules, and as such modules may be considered tangible entities capable of performing specified operations and may be configured or arranged in a certain manner. In an example, circuits may be arranged (e.g., internally or with respect to external entities such as other circuits) in a specified manner as a module. In an example, the whole or part of one or more computer systems (e.g., a standalone, client or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations. Accordingly, the term hardware module is understood to encompass a tangible entity, be that an entity that is physically constructed, specifically configured (e.g., hardwired), or temporarily (e.g., transitorily) configured (e.g., programmed) to operate in a specified manner or to perform part or all of any operation described herein. Considering examples in which modules are temporarily configured, each of the modules need not be instantiated at any one moment in time. For example, where the modules comprise a general-purpose hardware processor configured using software; the general-purpose hardware processor may be configured as respective different modules at different times. Software may accordingly configure a hardware processor, for example, to constitute a particular module at one instance of time and to constitute a different module at a different instance of time. Modules may also be software or firmware modules, which operate to perform the methodologies described herein.

The above description is intended to be illustrative, and not restrictive. For example, the above-described examples (or one or more aspects thereof) may be used in combination with each other. Other embodiments can be used, such as by one of ordinary skill in the art upon reviewing the above description. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

The present application provides for the following exemplary embodiments or examples, the numbering of which is not to be construed as designating levels of importance:
Example 1 provides an immersion liquid cooling device comprising: a base configured to be connected to one of two major surfaces of a motherboard and to surround one or more heat generating components connected to the motherboard; a cover connected to the base, the base, the cover, and a portion of the one of two major surfaces of the motherboard forming a sealed liquid cooling chamber; and a liquid inlet and a liquid outlet through which a dielectric liquid is configured to flow into and out of the cooling chamber.
Example 2 provides the cooling device of Example 1 and optionally further comprising a seal arranged between the base and the cover.
Example 3 provides the cooling device of Example 2 and optionally wherein the seal comprises a gasket.
Example 4 provides the cooling device of Example 2 or Example 3, and optionally wherein the seal comprises an adhesive.
Example 5 provides the cooling device of Example 4 and optionally wherein the adhesive comprises a silicone, epoxy, polyurethane, fluoropolymer based, or fluorinated ethylene propylene (FEP) adhesive.
Example 6 provides the cooling device of any of Examples 1 to 5, and optionally wherein the liquid inlet and liquid outlet are in the cover.
Example 7 provides the cooling device of Example 6 and optionally wherein the liquid inlet is in a first side of the cover and the liquid outlet is in a second side of the cover opposite the first side.
Example 8 provides the cooling device of Example 6 or Example 7, and optionally wherein the liquid inlet is adjacent a first corner of the cover and the liquid outlet is adjacent a second corner of the cover diagonal from the first corner.
Example 9 provides the cooling device of any of Examples 1 to 8, and optionally wherein the dielectric liquid comprises a single phase or two phase dielectric liquid.
Example 10 provides the cooling device of any of Examples 1 to 9, and optionally wherein the dielectric liquid comprises fluorocarbon, hydrofluoroether, fluoropolyether, synthetic oil, or fluoroketone.
Example 11 provides the cooling device of any of Examples 1 to 10, and optionally wherein at least one of the base and the cover comprises a polymer, epoxy, elastomer, or a combination thereof.
Example 12 provides the cooling device of any of Examples 1 to 11, and optionally wherein at least one of the base and the cover comprise a fiberglass-reinforced or carbon fiber-reinforced polymer.
Example 13 provides the cooling device of any of Examples 1 to 12, and optionally further comprising one or more flow directors extending from one or more inside surfaces of the cover.
Example 14 provides the cooling device of any of Examples 1 to 13, and optionally wherein at least a portion of the motherboard comprises a polymeric conformal coating.
Example 15 provides an immersion liquid cooling device comprising: a first enclosure configured to be connected to one of two major surfaces of a motherboard and to surround one or more heat generating components connected to the one of two major surfaces of the motherboard; a second enclosure configured to be connected to another of the two major surfaces of the motherboard opposite of the one of two major surfaces of the motherboard, the first enclosure and the second enclosure being fluidically connected and forming a sealed liquid cooling chamber; and a liquid inlet and a liquid outlet through which a dielectric liquid is configured to flow into and out of the cooling chamber.
Example 16 provides the cooling device of Example 15 and optionally wherein: the liquid inlet is a first liquid inlet and the liquid outlet is a first liquid outlet; and the first liquid inlet and the first liquid outlet are in the first enclosure.
Example 17 provides the cooling device of Example 16 and optionally further comprising a second liquid inlet in the second enclosure and a second liquid outlet in the second enclosure.
Example 18 provides the cooling device of Example 17 and optionally wherein: the first and second liquid inlets are in first sides of the first and second enclosures; and the first and second liquid outlets are in second sides of the first and second enclosures.
Example 19 provides the cooling device of Example 17 or Example 18, and optionally wherein: the first and second liquid inlets are a first corner of the first and second enclosures; and the first and second liquid outlets are adjacent a second corner of the first and second enclosures diagonal from the first corner.
Example 20 provides the cooling device of Example 15 and optionally wherein: the liquid inlet is a first liquid inlet and the liquid outlet is a first liquid outlet; and the first liquid inlet is in one of the first enclosure and the second enclosure and the first liquid outlet is in the other of the first enclosure and the second enclosure.
Example 21 provides the cooling device of any of Examples 15 to 20, and optionally wherein the dielectric liquid comprises a single phase or two-phase fluorocarbon, hydrofluoroether, fluoropolyether, synthetic oil, or fluoroketone liquid.
Example 22 provides the cooling device of any of Examples 15 to 21, and optionally wherein at least one of the first and second enclosures comprises a polymer, epoxy, elastomer, or a combination thereof.
Example 23 provides the cooling device of any of Examples 15 to 22, and optionally further comprising one or more flow directors extending from one or more inside surfaces of at least one of the first enclosure or the second enclosure.
Example 24 provides the cooling device of any of Examples 15 to 23, and optionally wherein at least a portion of the motherboard comprises a polymeric conformal coating.
Example 25 provides a method of cooling an electronic device, the method comprising: enclosing fewer than all of a plurality of heat generating components connected to a motherboard in a sealed liquid cooling chamber of an immersion liquid cooling device connected to the motherboard; and circulating a dielectric liquid through the cooling chamber to cool the fewer than all of the plurality of heat generating components.

Various aspects of the disclosure have been described. These and other aspects are within the scope of the following claims.

## Claims

1. An immersion liquid cooling device comprising:
a base configured to be connected to one of two major surfaces of a motherboard and to surround one or more heat generating components connected to the motherboard;
a cover connected to the base, the base, the cover, and a portion of the one of two major surfaces of the motherboard forming a sealed liquid cooling chamber; and
a liquid inlet and a liquid outlet through which a dielectric liquid is configured to flow into and out of the cooling chamber.

2. The cooling device of claim 1, further comprising a seal arranged between the base and the cover.

3. The cooling device of claim 2, wherein the seal comprises a gasket.

4. The cooling device of claim 2 or claim 3, wherein the seal comprises an adhesive.

5. The cooling device of claim 4, wherein the adhesive comprises a silicone, epoxy, polyurethane, fluoropolymer based, or fluorinated ethylene propylene (FEP) adhesive.

6. The cooling device of any of the preceding claims, wherein the liquid inlet and liquid outlet are in the cover.

7. The cooling device of claim 6, wherein the liquid inlet is in a first side of the cover and the liquid outlet is in a second side of the cover opposite the first side.

8. The cooling device of claim 6 or claim 7, wherein the liquid inlet is adjacent a first corner of the cover and the liquid outlet is adjacent a second corner of the cover diagonal from the first corner.

9. The cooling device of any of the preceding claims, wherein the dielectric liquid comprises a single phase or two phase dielectric liquid.

10. The cooling device of any of the preceding claims, wherein the dielectric liquid comprises fluorocarbon, hydrofluoroether, fluoropolyether, synthetic oil, or fluoroketone.

11. The cooling device of any of the preceding claims, wherein at least one of the base and the cover comprises a polymer, epoxy, elastomer, or a combination thereof.

12. The cooling device of any of the preceding claims, wherein at least one of the base and the cover comprise a fiberglass-reinforced or carbon fiber-reinforced polymer.

13. The cooling device of any of the preceding claims, further comprising one or more flow directors extending from one or more inside surfaces of the cover.

14. The cooling device of any of the preceding claims, wherein at least a portion of the motherboard comprises a polymeric conformal coating.

15. A method of cooling an electronic device, the method comprising:
enclosing fewer than all of a plurality of heat generating components connected to a motherboard in a sealed liquid cooling chamber of an immersion liquid cooling device connected to the motherboard; and
circulating a dielectric liquid through the cooling chamber to cool the fewer than all of the plurality of heat generating components.
